# EUROPEAN PATENT APPLICATION

(11) **EP 4 383 961 A1**
(43) Date of publication of application: **12.06.2024**
(21) Application number: 22211939.8
(22) Date of filing: 07.12.2022
(51) Int. Cl.: H05K 3/42, H05K 3/00, B82Y 40/00, H05K 1/09, B82Y 30/00

(54) **METHOD FOR SELECTIVELY STRUCTURING A MEMBRANE**

(71) Applicant: Dyconex AG, 8303 Bassersdorf (CH)
(72) Inventor: Steim, Roland, 8600 Dübendorf (CH); Hauer, Marc, 8610 Uster (CH)
(74) Representative: Biotronik Corporate Services SE

(57) **Abstract**

The present invention relates to a method for selectively structuring a membrane (1), the method comprising the following steps: a) providing a membrane (1) having pores (4); b) selectively applying an ink (5) onto a first surface (6) of the membrane (1) so that the membrane (1) comprises ink-covered portions (2) and ink-free portions (3); c) allowing the ink (5) to enter the pores (4) in the ink-covered portions (2) of the membrane (1); and d) receiving a selectively structured membrane (1) having ink-filled pores (40) and ink-free pores (41).

## Description

The present invention relates to a method for selectively structuring a membrane according to the preamble of claim 1, to a membrane obtainable with such method according to the preamble of claim 14, as well as to uses of such membrane according to the preamble of claim 15.

There exist different membranes comprising fine end-to-end pores or micro-channels that are often distributed over the whole membrane area in a uniform, statistic manner. Examples of such membranes are track-etched membranes that are manufactured by beaming polymer films with heavy ions.

According to prior art techniques for structuring such membranes, the whole membrane area is coated with a photoresist. The specific structure to be introduced onto the surface of the membrane is then exposed to light. After developing the photoresist and stripping the non-exposed parts of the photoresist, the desired structure remains on the surface of the membrane. However, since the pores of such membranes typically have a very small diameter, strong capillary forces act upon the photoresist coated onto the surface of the membrane. Consequently, the photoresist enters into the pores and is difficult to remove after developing and stripping. Consequently, the desired surface structure is accompanied by a non-desired resist contaminations. Thus, the functionality of the film is negatively influenced. Also, the un-used pores tend to absorb any liquid in process chemistry which lead carryover contamination.

It is an object of the present invention to provide an easier and cheaper way of structuring a membrane than the ways known from prior art.

This object is achieved with a method for selectively structuring a membrane having the features of claim 1. Such a method comprises the steps explained in the following.

First, a membrane having pores is provided. The term "pore" as used herein refers to through-going pores or openings in the membrane, i.e., to end-to-end pores that penetrate the membrane from a first side to a second side like a microchannel. These pores typically have a circular cross section but may also have cross sections of other geometry (like an elliptical cross section). The membrane can also be denoted as foil.

Afterwards, an ink is selectively applied, i.e., in a spatially resolved manner, onto a first surface of the membrane. As a result, the membrane comprises ink-covered portions and ink-free portions. The application can be done with an ink applicator employing a piezo technique, such as an inkjet printer.

In a further method step, the ink is allowed to enter the pores in the ink-covered portions of the membrane. This entering of the ink into the pores can be accomplished by capillary forces drawing the ink into the pores.

Afterwards, a selectively structured membrane having ink-filled pores and ink-free pores is received. The ink that has entered the pores serves for clogging these pores, wherein the other pores remain open. Since the ink is applied onto the first surface of the membrane in a structured manner (i.e., representing a space-resolved pattern covering only a part of the membrane, wherein other parts of the membrane remain free of ink), no undesired accidental clogging of pores that should remain open will occur. Rather, the ink will only enter into those pores that are in the membrane region that has been previously covered with the ink.

The ink-filled pores may also be denoted as closed pores, wherein the ink-free pores may be denoted as open pores. Thus, the selectively structured membrane comprises open pores and closed pores distributed over the membrane in a defined manner corresponding to the applied structuring by the deposited ink. The membrane is passivated at the printed sites (i.e. in all areas in which the ink has been applied to the surface of the membrane and has been entered into the pores of the membrane).

Compared with a classic photoresist process, the presently claimed method is a simple and cheap way of structuring a porous membrane. There is no risk that pores that should remain open will be inadvertently clogged with residual ink. Furthermore, the presently claimed method requires much less process steps than classic photoresist processes and also requires less process steps that could negatively influence the functionality of the pores of the membrane. Particularly, clogging all unneeded pores will minimize penetration of the resist into the pores and thereby will ease the resist removal.

The inkjet application process has a very high spatial resolution and thus allows to selectively close some of the pores of the membrane in a finely structured manner. Consequently, the properties of the membrane are selectively changed and can afterwards be used in a spatially selective manner.

Such selectively structured membrane allows a selective permeability for specific compounds. The membrane can be used for filtering specific substances or for transporting ions. A gas-permeable membrane can be used for manufacturing a sensor.

In an embodiment, the pores have a cross-sectional diameter lying in a range of from 10 nm to 100 µm, in particular of from 20 nm to 75 µm, in particular of from 30 nm to 50 µm, in particular of from 40 nm to 25 µm, in particular of from 50 nm to 10 µm, in particular of from 60 nm to 5 µm, in particular of from 70 nm to 1 µm, in particular of from 80 nm to 750 nm, in particular of from 90 nm to 500 nm, in particular of from 100 nm to 250 nm. If the cross section of the pores does not correspond to an ideal circle, the diameter is to be understood as average diameter taking into account the longest and the shortest cross-sectional distance between two circumferential points through a center of the cross section of the pore.

After having applied the ink onto the first surface of the membrane, the ink may have fully entered into some of the pores to form ink-filled pores. Alternatively, the ink may form ink-filled pores and remain additionally present on the first surface of the membrane (depending on the ratio between the volume of the applied ink and the volume of the pores to be clogged by the ink). In an embodiment, the method comprises a further step in which the residual ink is removed from the surface of the ink-covered portions of the membrane. The surface of the ink-covered portions of the membrane constitutes a subsection of the first surface. By removing the ink from the surface of the ink-covered portions of the membrane, a particularly smooth membrane surface will result.

In an embodiment, removing the ink is carried out mechanically and/or chemically. In an embodiment, a solvent like an organic solvent is used for chemically removing the ink. Aprotic polar organic solvents are particularly appropriate for this purpose. Some appropriate examples of aprotic polar organic solvents are xylene, acetone, isopropanol, and chlorobenzene.

To avoid an undesired clogging of open pores by residual ink during the ink removal process, the residual ink is, in an embodiment, removed in a dry state of the residual ink. Then, such risk of clogging pores in the ink-free portions of the membrane is significantly reduced or even totally avoided.

In an embodiment, the ink (or a polymer being present in the ink) is cross-linked after having been allowed to enter the pores in the ink-covered portions of the membrane. By such cross-linking, it is less likely that the ink inadvertently exits out of the ink-filled pores. Cross-linking typically leads to stronger intermolecular forces within the ink that also serve for better adhesion of the cross-linked ink to the surrounding membrane. The cross-linked ink helps in stabilizing the membrane.

In an embodiment, the cross-linking is accomplished by heating the membrane and/or by irradiating the membrane with radiation. Thermal radiation such as infrared radiation is a particularly suited possibility for introducing heat into the membrane and the ink to be cross-linked. The radiation may also include radiation of microwave or ultraviolet light.

In an embodiment, the ink has a dynamic viscosity, in particular measured with a viscometer according to, e.g., EN ISO 3219, at 20 °C lying in a range of from 0.1 mPa·s to 5 mPa·s, in particular of from 0.2 mPa·s to 4.5 mPa·s, in particular of from 0.3 mPa·s to 4 mPa·s, in particular of from 0.4 mPa·s to 3.5 mPa·s, in particular of from 0.5 mPa·s to 3 mPa·s, in particular of from 0.6 mPa·s to 2.5 mPa·s, in particular of from 0.7 mPa·s to 2 mPa·s, in particular of from 0.8 mPa·s to 1 mPa·s.

An ink having such a viscosity can be particularly easy soaked into the pores due to capillary forces.

In an embodiment, the ink has a surface tension, in particular measured according to the Du Noüy ring method, at 20 °C lying in a range of from 15 mN/m to 50 mN/m, in particular of from 17.5 mN/m to 45 mN/m, in particular of from 20 mN/m to 40 mN/m, in particular of from 22.5 mN/m to 35 mN/m, in particular of from 25 mN/m to 30 mN/m.

In an embodiment, the ink-free pores are at least partly metalized or at least partly filled with a metallic material. In one embodiment, the metallic material essentially consists of or comprises copper, palladium, nickel, antimony, or a mixture thereof. In one embodiment, the metallic material comprises antimony and copper. In one embodiment, ink-free pores are at least partly metalized or at least partly filled with the metallic material such that the metallic material extends from the first side (e.g., top side) to the second side (e.g., bottom side) of the membrane. In one embodiment, the ink-free pores are at least partly metalized or at least partly filled with the metallic material by galvanically plating.

Particularly, the ink enters into the pores simply by gravity or by the capillary forces of the pores, as outlined above.

In an embodiment, the membrane comprises or consists of a track-etched polymer, in particular track-etched polyimide, polyester and/or polycarbonate.

In an embodiment, the surface properties of at least the first surface are modified prior to selectively applying the ink onto the first surface. Such surface modification can facilitate filling the pores in the ink-covered portions of the membrane with the ink. In an embodiment, not only the first surface, but also a surface of the pores (facing the ink filled into the pores) is surface-modified. In an embodiment, alternatively or additionally the second surface is surface-modified. This can facilitate drawing the ink through the pores to be filled by the ink by capillary forces, or gravity.

In an embodiment, the surface modification is carried out by a plasma activation, e.g. by a corona discharge.

In an aspect, the present invention relates to a method for manufacturing a spatially resolved metal structure or a nanowire. This method comprises the steps explained in the following.

First, a membrane having pores is provided. Afterwards, an ink is selectively applied, i.e. in a spatially resolved manner, onto a first surface of the membrane. As a result, the membrane comprises ink-covered portions and ink-free portions.

In a further method step, the ink is allowed to enter the pores in the ink-covered portions of the membrane. A selectively structured membrane having ink-filled pores and ink-free pores is received.

Optionally, the membrane is at least partially, in particular fully, dissolved, e.g., by an appropriate organic solvent. In case of partially dissolving the membrane, the pore structure filled with metallized ink will remain as spatially resolved metal structure. If the membrane is fully dissolved and does no longer provide a structural support, a plurality of nanowires (resulting from the ink in the previously existing pores) is obtained.

In one embodiment of the method according to the invention, one or more ink-free pores are metallized or at least partly filled with a metallic material, e.g., by galvanic plating.

In one embodiment of the method, a first group of one or more ink-free pores are covered by a temporary material layer, e.g., by way of a removable photoresist layer. In one embodiment, a second group of one or more ink-free pores, particularly the remaining ink-free pores not covered by the temporary material, are at least partly metallized or at least partly filled with a first metal composition. In one embodiment, the temporary material layer is removed, and the first group of one or more ink-free pores, particularly the ink-free pores being uncovered by removal of the temporary layer, are at least partly metallized or at least partly filled with a second metal composition.

In an aspect, the present invention relates to a membrane obtainable by a method for selectively structuring the membrane as described above.

In an aspect, the present invention relates to a porous membrane (i.e., a membrane comprising pores), wherein a first part of the pores consists of ink-filled pores and a second part of the pores consists of ink-free pores. Such membrane can be manufactured by the previously explained method.

In an aspect, the present invention relates to the use of such a membrane for manufacturing a sensor or a printed circuit board. Thermal sensors are particularly appropriate sensors for such purpose. Other claimed uses of such a membrane are the use of the membrane for filtering substances or compositions and the use for (selectively) transporting ions. Another claimed use is the use of such membrane as matrix for manufacturing a metal structure or a nanowire.

All embodiments of the various methods can be combined in any desired manner and can be transferred either individually or in any arbitrary combination to the respective other methods, to the membrane and to the uses of the membrane. Likewise, all embodiments of the membrane can be combined in any desired way and can be transferred either individually or in any arbitrary combination to the individual methods and to the uses of the membrane. Finally, all embodiments of the described uses can be combined in any desired way and can be transferred either individually or in any arbitrary combination to the described methods and the described membrane.

Further details of aspects of the present invention will be explained in the following making reference to exemplary embodiments and accompanying Figures. In the Figures:
- Figure 1: shows a schematic top view onto an embodiment of a membrane being obtainable with the presently described method;
- Figure 2A: shows a first step of an embodiment of a method for selectively structuring a membrane;
- Figure 2B: shows a second step of this method; and
- Figure 2C: shows a third step of this method.

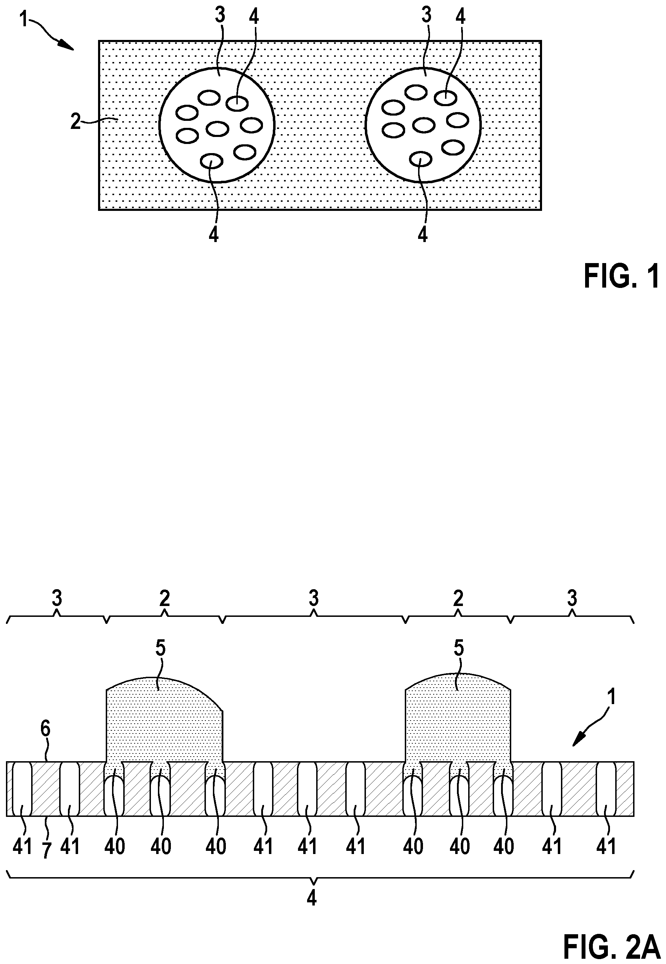

Figure 1 shows a schematic top view onto a membrane 1 that is partly covered with ink so that ink-covered portions 2 and ink-free portions 3 are formed. In the ink-free portions 3, a plurality of pores 4 can be seen that have been introduced in the membrane 1 in a track-etched process (i.e., by beaming heavy ions onto the membrane 1 and afterwards performing an etching process within the channels formed by the heavy ions). The pores 4 have an elliptical cross-sectional shape. For better visualization, only some of the pores 4 are marked with the respective numeral reference.

The ink-covered portion 2 of the membrane 1 also comprises such pores 4. However, they are covered by the ink and are not visible in the depiction of Figure 1.

Figure 2A shows a first cross-sectional view through the membrane 1 that is partly covered with an ink 5. In this and in all following Figures, similar elements will be denoted with the same numeral reference.

By applying the ink 5 onto the first surface 6 of the membrane 1, ink-covered portions 2 as well as ink-free portions 3 of the membrane 1 are formed. The ink 5 applied onto the first surface 6 of the membrane 1 enters the pores 4 being present in the ink-covered portions 2 and advances towards a second surface 7 of the membrane 1 being opposite the first surface 6. It should be noted that the ink 5 is applied onto the first surface 6 in a spatially resolved manner by printing very fine structures onto the membrane 1.

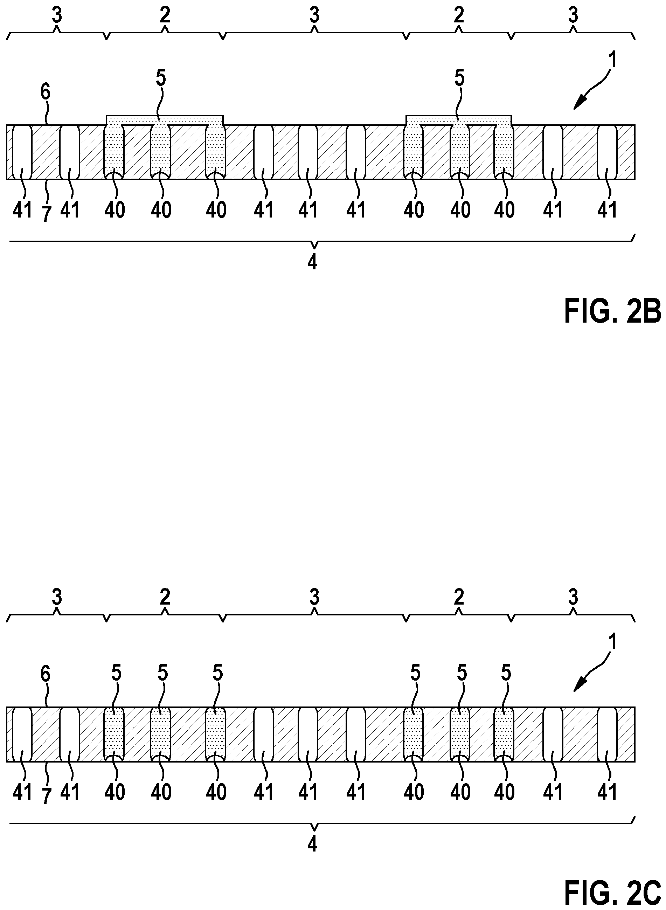

Figure 2B shows the membrane 1 of Figure 2A after a further process step in which the ink 5 has fully filled some of the pores 4 so that ink-filled pores 40 and ink-free pores 41 result that make up together the pores 4. A part of the ink 5 is still present on top of the first surface 6 in the ink-covered portions 2 of the membrane 1.

This part of the ink 5 is removed with an appropriate organic solvent in another method step. The result is depicted in Figure 2C. Here, the first surface 6 of the membrane 1 is plane and smooth irrespective whether it forms the top terminus of the membrane 1 over ink-filled pores 40 or over ink-free pores 41. Thus, the membrane 1 only comprises spatially selectively closed pores 40 and spatially selectively pores 41, wherein neither the first surface 6 nor the second surface 7 is negatively influenced by the ink 5 previously printed onto the first surface 6 of the membrane 1.

## Claims

1. Method for selectively structuring a membrane (1), the method comprising the following steps:
a) providing a membrane (1) having pores (4);
b) selectively applying an ink (5) onto a first surface (6) of the membrane (1) so that the membrane (1) comprises ink-covered portions (2) and ink-free portions (3);
c) allowing the ink (5) to enter the pores (4) in the ink-covered portions (2) of the membrane (1); and
d) receiving a selectively structured membrane (1) having ink-filled pores (40) and ink-free pores (41).

2. Method according to claim 1, **characterized in that** step d) is followed by removing residual ink (5) from a surface of the ink-covered portions (2) of the membrane (1).

3. Method according to claim 2, **characterized in that** the residual ink (5) is removed in a dried state of the residual ink (5).

4. Method according to any of the preceding claims, **characterized in that** the method further comprises a step of crosslinking the ink (5) in the ink-filled pores (40).

5. Method according to claim 4, **characterized in that** the crosslinking is carried out by at least one of applying heat to the membrane (1) or irradiating the membrane (1) with radiation.

6. Method according to any of the preceding claims, **characterized in that** the ink (5) has a dynamic viscosity measured at 20 °C lying in a range of from 0.1 mPa·s to 5 mPa·s.

7. Method according to any of the preceding claims, **characterized in that** the ink-free pores (41) are at least partly metalized or at least partly filled with a metallic material.

8. Method according to claim 7, **characterized in that** the metallic material essentially consists of or comprises copper, palladium, nickel, antimony or a mixture thereof.

9. Method according to claim 7 or 8, **characterized in that** the ink-free pores (41) are at least partly metalized or at least partly filled with the metallic material by galvanically plating.

10. Method according to any of the preceding claims, **characterized in that** the step of allowing the ink to enter the pores (4) in the ink-covered portions (2) of the membrane (1) comprises applying a pressure lying in a range of from 100 mbar to 900 mbar at least to a second surface (7) of the membrane (1) lying opposite the first surface (6).

11. Method according to any of the preceding claims, **characterized in that** the membrane (1) comprises a track-etched polymer.

12. Method according to any of the preceding claims, **characterized in that** the membrane (1) comprises a liquid crystal polymer.

13. Method according to any of the preceding claims, **characterized in that** surface properties of at least the first surface (6) are modified prior to selectively applying the ink (5) onto the first surface (6).

14. Membrane comprising pores, **characterized in that** a first part of the pores (4) consists of ink-filled pores (40) and a second part of the pores (4) consists of ink-free pores (41).

15. Use of a membrane (1) according to claim 14 for manufacturing a sensor or a printed circuit board.
